(19) Europäisches Patentamt
European Patent Office
Office européen des brevets

(11) Publication number: **0 010 897**
**B1**

(12) **EUROPEAN PATENT SPECIFICATION**

(45) Date of publication of patent specification: **25.01.84**

(51) Int. Cl.[3]: **G 03 C 1/68**

(21) Application number: **79302225.2**

(22) Date of filing: **16.10.79**

(54) **Polymerisable compositions, derived coatings and other polymerised products.**

(30) Priority: **27.10.78 GB 4223578**

(43) Date of publication of application:
**14.05.80 Bulletin 80/10**

(45) Publication of the grant of the patent:
**25.01.84 Bulletin 84/4**

(84) Designated Contracting States:
**AT BE CH DE FR GB IT LU NL SE**

(56) References cited:
**FR - A - 2 298 558**
**FR - A - 2 322 897**
**US - A - 3 741 769**
**US - A - 4 028 204**

(73) Proprietor: **IMPERIAL CHEMICAL INDUSTRIES PLC**
**Imperial Chemical House Millbank**
**London SW1P 3JF (GB)**

(72) Inventor: **Ledwith, Anthony**
**193 Wigan Road Standish**
**Wigan Lancashire (GB)**
Inventor: **McGuiness, Robert Clayton**
**Am Lohbusch 2**
**D-4006 Erkrath 1 (DE)**

(74) Representative: **Kerr, Michael Arthur et al,**
**Imperial Chemical Industries PLC Legal Department : Patents Po Box 6**
**Welwyn Garden City Herts, AL7 1HD (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**EP 0 010 897 B1**

# Photopolymerisable compositions, derived coatings and other polymerised products

This invention relates to photopolymerisable compositions, to coatings and to other products obtained by polymerisation of the photopolymerisable compositions.

In our British Patent 1,539,192 we have described and claimed *inter alia* a photopolymerisable composition comprising at least one acid-polymerisable or acid-curable material and as photosensitiser at least one iodonium salt of formula

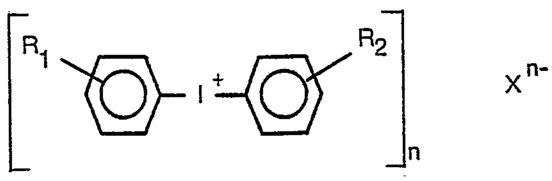

wherein n is 1 or 2, $R_1$ and $R_2$, which may be the same or different each is a hydrogen or halogen atom, a nitro group or a hydrocarbon or substituted hydrocarbon group or heterocyclic group, and $X^{n-}$ is an anion derived from an acid which is capable of polymerising or curing the acid-polymerisable or acid-curable material. We have also described the preparation of a polymeric material by exposing the composition to radiation of a suitable wavelength.

British Patent 1,516,351 (General Electric Company) describes and claims *inter alia* a curable composition comprising

(A) a monoepoxide, an epoxy resin or a mixture thereof, polymerisable to a higher molecular weight state and

(B) a radiation sensitive aromatic halonium salt in an amount capable of effecting the cure of (A) by release of a Lewis Acid catalyst when exposed to radiant energy.

British Patent 1,491,539 (Minnesota Manufacturing and Mining Company) describes and claims *inter alia* a photopolymerisable composition comprising

(a) an organic material which is cationically polymerisable and

(b) 0.5 to 30 parts by weight, per 100 parts by weight of the organic material, of an aromatic iodonium complex salt photoinitiator of the formula

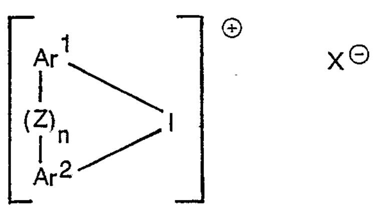

in which

$Ar^1$ and $Ar^2$ may be the same or different and represent aromatic groups having 4 to 20 carbon atoms which are phenyl, thienyl, furanyl, or pyrazolyl groups which may optionally be substituted or have one or more fused benzo rings,

Z represents an oxygen atom, a sulphur atom,

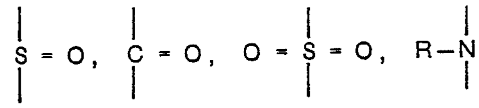

in which

R represents a hydrogen atom, lower alkyl group or carboxylic acid acyl group, a direct carbon-to-carbon bond, or

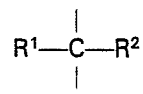

in which

$R^1$ and $R^2$ are the same or different and represent a hydrogen atom, an alkyl group having 1 to 4 carbon atoms, or an alkenyl radical having 2 to 4 carbon atoms,

n is 0 or 1, and

$X^-$ is a tetrafluoroborate, hexafluorophosphate, hexafluoroarsenate, hexachloroantimonate or hexafluoroantimonate anion.

British Patent 1,491,539 also states at page 6, lines 31—38 that the defined aromatic iodonium complex salts are of themselves photosensitive only in the ultra-violet range of the spectrum but it indicates that the salts may be sensitised to the near UV and visible range of the spectrum by sensitisers for known photolysable organic halogen compounds as described in US. Patent 3,729,313. Illustrative sensitisers are said to be found in the categories aromatic amines, aminoketones and coloured aromatic polycyclic hydrocarbons but claim 14 of the patent refers only to the use of a sensitising dye. US Patent 3,729,313 relates to a photosensitive admixture which generates free radicals on exposure to light. The admixture comprises as essential components a diaryliodonium compound and a sensitiser for known photolysable organic halogen compounds. Since US Patent 3,729,313 indicates that free radicals are generated on exposure to light only when both components are present in admixture it must be understood that the sensitiser component of itself will not generate free radicals to any significant extent on exposure to ultraviolet or visible light.

In a review article by J. V. Crivello (who is named as the inventor in British Patent 1,516,351 mentioned above) entitled "Photo-initiated Cationic Polymerisation" (see page 63 of "U.V. Curing: Science & Technology", 1978, published by Technology Marketing Corporation and edited by P. Pappas) it is stated that diaryliodonium and triarylsulphonium salts show certain parallel behaviour with respect to

their photochemical properties. In particular it is stated that their photolysis is not accelerated by radical initiators. Crivello also states at page 39 that the possibility that photolysis of diaryliodonium salts might involve a radical chain reaction must be ruled out.

Therefore it is surprising that we have now found that the rate of polymerisation of materials polymerisable by an acid-catalysed mechanism in the presence of diaryl halonium salts may be increased and in many cases the wavelength spectrum of sensitivity of the salts may be extended towards the visible region when there is present in a photopolymerisable composition of the general type described in the above-mentioned British Patent Specifications a photosensitive halonium salt and a material which under the conditions of photopolymerisation, by itself or by hydrogen abstraction from some other component of the composition, will yield a significant proportion of free radicals. This finding is of particular importance with regard to the formulation of photopolymerisable compositions in which there is present a component which plays no part in the photopolymerisation process but which absorbs radiation in that same region of the wavelength spectrum which is required for activation of the halonium salt. Such components include for example pigments particularly titanium dioxide which absorbs radiation substantially in the ultra-violet region.

According to this invention we provide a photopolymerisable composition capable of polymerisation by an acid-catalysed mechanism under the influence of ultraviolet and/or visible light which comprises the components:

(a) At least one material capable of polymerisation by an acid-catalysed mechanism to a polymeric material of higher molecular weight state;

(b) a photosensitive aromatic halonium salt which is represented by the formula:

I) $$\left[ R_1 - Hal - R_2 \right]^{+}_{n} \quad X^{n-}$$

or

II) 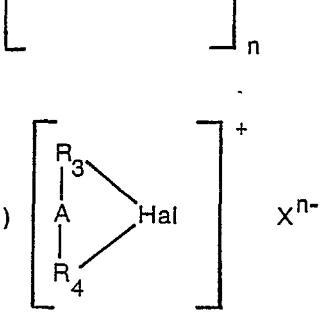

wherein n is 1 or 2; Hal is a halogen radical selected from Cl, Br and I; $R_1$ and $R_2$ are monovalent aromatic carbocyclic or aromatic heterocyclic organic radicals containing 4—20 carbon atoms, the same or different which may be substituted; $R_3$ and $R_4$ are divalent aromatic carbocyclic or aromatic heterocyclic radicals containing 4—20 carbon atoms, the same or different, which may be substituted and which may be directly linked through a carbon-carbon bond (when A = a direct bond) or indirectly linked when A is a hetero atom or a group containing a hetero atom or an alkyl or alkenyl radical containing 4—20 carbon atoms; and $X^{n-}$ is an anion derived from an acid which is capable of polymerising the material (a) of the composition by an acid-catalysed mechanism to a higher molecular weight state; and

(c) a conventional photosensitive free radical generator other than 2-chlorothioxanthone which under the influence of ultraviolet and/or visible light generates a significant proportion of free radicals which are readily converted to the corresponding carbocation by the halonium salt either (i) by intramolecular cleavage, or (ii) by intermolecular hydrogen abstraction in conjunction with a component of the composition other than the photosensitive aromatic halonium salt.

Within the term "polymerisation by an acid-catalysed mechanism" we include polymerisation by an acid-catalysed cationic addition mechanism and polymerisation by an acid-catalysed condensation mechanism.

Preferably the photopolymerisable composition contains a further component (d) which plays no direct part in the photopolymerisation process but which, when the composition is irradiated to cause polymerisation, absorbs at least some of that irradiation to which in the absence of said component (d) the halonium salt would be sensitive. Suitable such materials include, for example, pigments and other additives which may be used for example in the formulation of paints, other surface coatings and other polymerised products. A particularly appropriate pigment is titanium dioxide.

The definition of component (c) does not embrace the sensitisers referred to at page 6 of British Patent 1,491,539 referred to above which we understand to be limited in scope to those sensitisers described in US Patent 3,729,313. We also understand that the sensitisers of US Patent 3,729,313 would be incapable of providing free radicals. Further, the definition of component (c) does not embrace the organic dyes disclosed by Crivello in US Patent 4,026,705 for use in combination with diarylhalonium salts. Whilst US Patent 4,026,705 does refer to the use of 4,4'-bis-dimethylaminobenzophenone, (Michlers Ketone) and 4,4'-bisdiethylaminobenzophenone in conjunction with a diaryliodonium salt, it is clear that such materials are not present to provide a significant proportion of free radicals according to our invention, and this is confirmed by the statement at page 63 of "UV Curing: Science & Technology", (1978) mentioned above, by J. C. Crivello (who is the named inventor in US Patent 4,026,705).

Furthermore we do not include these specific ketones within the scope of our invention.

We are also aware of French Patent No. 2,322,897 which refers to the use of 2-chlorothioxanthone as a sensitiser in compositions which comprise an iodonium salt and an epoxy resin. The presence of the sensitiser is said to determine that region of the spectrum to which the iodonium salt is sensitive but there is no reference to the generation of free radicals. Since 2-chlorothioxanthone can generate free radicals as required in the present invention we exclude this compound from the definition of component (c).

For the formulation of a fully effective photopolymerisable composition, component (c) is preferably of good solubility in the material (a) to be polymerised. We have found that the solubility of (c) in acetone is a useful general guide to the solubility of (c) in (a) and that preferred components (c) can be usefully selected on this basis. Thus it is preferred that component (c) has a solubility in acetone which is greater than 2% by weight of (c) based on the volume of acetone.

It is also preferred that the component (c) of the photopolymerisable composition is one which does not yield a coloured product when irradiated in the presence of the halonium salt. Since the present compositions find important application as coatings in which colour or lack of colour must be closely controlled it is clearly important that the light induced products of interaction between the polymerisable material, the halonium salt and component (c) are not intensely coloured and preferably they are substantially free from colour. Thus unsuitable materials as component (c) include for example the derivatives of benzophenone mentioned in US Patent 4,026,705 and other amines and sulphur compounds.

Suitable materials as component (c) which yield a significant proportion of free radicals useful in the present invention under the conditions of polymerisation to be employed can be determined by reference to the following papers: A. Ledwith, Pure and Applied Chem., *49* 431—441 (1977); Hutchinson & Ledwith, Adv. Polymer Science, *14*, 49 (1974); and to "Free Radicals", Volumes I and II, by J. K. Kochi (Wiley 1973). Thus it is preferred to employ as component (c) conventional photosensitive free radical generators which generate a significant proportion of free radicals and such as are disclosed in these references.

Different materials (c) will in many cases yield free radicals under different conditions of irradiation and clearly in practising this invention one will normally choose that material which provides a significant proportion of free radicals to the optimum extent under any chosen irradiation conditions. The irradiation may be desired in the ultraviolet and/or the visible part of the spectrum for example at a wavelength in the range about 200—380 nm for ultraviolet and in the range 380—700 nm for the visible. It is a particular advantage of this invention that in many cases photopolymerisable compositions may be polymerised when irradiated with visible light, i.e. in the range 380—700 nm.

Particularly suitable materials as component (c) are those which on irradiation yield free radicals which are readily converted to the corresponding carbocations by the halonium salt. The free radical to be oxidised may be that resulting from cleavage of from hydrogen abstraction.

Particularly suitable types of material which may be used as component (c) (i) of the photopolymerisable compositions include benzoin; the benzoin alkyl ethers, for example benzoin methyl ether and benzoin ethyl ether; derivatives of acetophenone, for example alkoxy aryl acetophenones such as 2,2-dimethoxy-2-phenyl acetophenone and 2,2-diethoxyacetophenone, and 1-phenyl-1, 2-propanedione-2-O-benzoyl oxime; and halogenated acetophenones such as 2,2-dichloroacetophenone.

Particularly suitable types of material which may be used as component (c) (ii) include aromatic diketones, for example, 9,10-phenanthrenequinone, 9-10-anthraquinone, and benzil, and derivatives of these ketones; benzophenone and its derivatives; compounds capable of diradical formation such as O-methylacetophenone; materials of structure

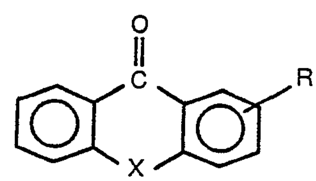

wherein X = O, S, $CH_2$ or a direct carbon-to-carbon bond, i.e. xanthone, thioxanthone, anthrone and fluorenone respectively when R = H, and derivatives of such materials for example where R = halogen, alkyl or substituted alkyl, i.e. derivatives such as 2-isopropylthioxanthone and 2-methylthioxanthone; and certain aromatic aldehydes such as piperonal of structure

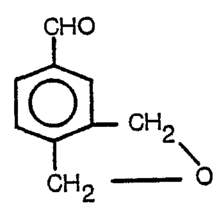

and derivatives thereof; and many halogenated materials such as the arylchloromethyl and arylchlorosulphonyl derivatives which are referred to in Table II at page 19 of the book mentioned above edited by P. Pappas.

In the case of components (c) (ii) they will normally abstract hydrogen from a hydrogen-donor which is present in the photopolymerisable composition and this will commonly be the material which is to be polymerised. However other suitable components of a photopolymerisable composition which may act as a hydrogen-donor include tetrahydrofuran, hydrocarbons and ethers or even the component (c) itself.

Unsuitable materials as component (c) (ii) include those which contain groups reactive with organic carbocations, e.g. amines and sulphur compounds. Examples of such unsuitable types are 4,4′-dimethylaminobenzophenone (Michlers Ketone) and 4,4′-diethylaminobenzophenone.

The amount of material (c) is not usually critical but will usually be from 0.01% to 10%, and preferably from 0.5% to 5% by weight based on the weight of polymerisable material in the composition. The optimum amount will usually be about 0.5—3% by weight.

Suitable radicals $R_1$, $R_2$, $R_3$ and $R_4$ in formulae I) and II) include phenyl, thienyl, furanyl and pyrazolyl.

Suitable hetero atoms A = oxygen and sulphur and suitable hetero atom-containing groups A =

$$S{=}O,\ C{=}O,\ O{=}S{=}O,\ R{-}N$$

Suitable substituents in the groups $R_1$, $R_2$ $R_3$ and $R_4$ include halogen, nitro, alkyl, alkoxy, cycloalkyl, aryl, alkaryl, aralkyl, and substituted such groups, and substituted or unsubstituted heterocyclic groups.

Particularly suitable substituents are those which extend the absorption of the halonium compound towards the visible region, e.g. nitro groups.

The anion $X^{(n-)}$ may be for example a halogen-containing complex ion. The complex ion may be a halogenide of a metal or a metalloid element, for example, a polyhalide of boron, antimony, phosphorous tin, bismuth, arsenic or iron. Examples of suitable anions are $BF_4^-$, $SbCl_6^-$, $SbF_6^-$, $SnCl_6^{--}$, $PF_6^-$, $AsF_6^-$, $FeCl_4^-$, $BiCl_5^{--}$, or $R_6SO_3^-$, where $R_5$ is an aromatic hydrocarbon radical having 6—13 carbon atoms, an alkyl radical having 1—8 carbon atoms, halogenated derivatives thereof or $R_5$ is fluorine. Other suitable anions are $ClO_4^-$ or $CF_3COO^-$ or $ArsO_3^-$, or $HSO_4$, or $NO_3^-$ or the picrate ion.

Particularly suitable halonium salts are the iodonium salts. Particularly suitable iodonium salts include those which are disclosed in our British Patent No. 1,539,192, for example 4,4′-dimethyl-diphenyl iodonium hexafluorophosphate, 3,3′-dinitrodiphenyl iodonium hexafluorophosphate, 4,4′-dichlorodiphenyl$I^+$ hexafluoroarsenate, 4,4′-dimethoxydiphenyl$I^+$ hexafluoroantimonate.

The ability of a particular halonium salt to yield fragments capable of polymerising a particular material (a) reflects the ability of the corresponding proton acid, i.e. the proton acid containing the same anion as the halonium salt, to polymerise that material. If the proton acid polymerises the material, then the halonium salt containing the same anion also will be capable of providing fragments which will polymerise the material. Thus the suitability of a particular halonium salt for use with a particular polymerisable material is readily determined simply by mixing the corresponding proton acid with the material.

The halonium salts used in this invention are normally solids at ordinary temperatures and they are usually incorporated in the polymerisable material (a) in the form of a solution in some suitable liquid. Any inert liquid diluent in which the halonium salt is sufficiently soluble may be used, and examples of suitable diluents are halogenated hydrocarbons, e.g. methylene chloride, ketones, e.g. acetone. We prefer to employ a liquid diluent of low boiling point, e.g. below 150°C, in order to facilitate removal of the diluent from the composition. The amount of the diluent used is not critical but preferably is just sufficient to dissolve the appropriate amount of the halonium salt. After incorporation of the halonium salt in the composition, the diluent may be removed, if desired, before the composition is irradiated. Removal of the diluent prior to irradiating the composition may be desirable in cases where the diluent is a solvent for the polymerisable material. In the case where the material is, or contains, a monomer, the halonium salt may be soluble in the material and a diluent may not be required.

The amount of the halonium salt is not critical but will usually be from 0.01% to 10.0%, and preferably from 0.5% to 5.0% by weight based on the weight of polymerisable material in the composition. In general increasing the amount of the halonium salt results in an increase in the rate of polymerisation or curing achieved although in practice there is little point in using an amount of greater than 10% by weight.

The halonium salt preferably should be soluble in the polymerisable material (a) into which it is incorporated and the solubility of a particular halonium salt in the material may limit the amount of that salt which can be incorporated. (see above). The polymerisation reaction initiated by irradiating the composition is exothermic and use of too large an amount of the halonium salt may result in a very rapid rise in temperature and loss of control over the reaction conditions. The optimum amount of the halonium salt will usually be about 3% to 5% by weight but will depend upon the particular salt and polymerisable material employed and the radiation source, and can be determined by simple experiment.

In general, polymerisation or curing of the composition proceeds readily when the composition is irradiated at ambient temperature although the reaction is exothermic and may be

accompanied by a rise in temperature of the composition. The rate of polymerisation or curing in general may be increased by irradiating the composition at an elevated temperature.

The present invention thus provides a method of producing a polymeric composition which consists in irradiating with ultraviolet and/or visible light a photopolymerisable composition as described above. The invention also provides coatings and a polymeric composition when produced by this method.

Particularly useful photopolymerisable compositions according to the invention are those which are to be applied as coatings to surfaces and which are preferably pigmented. Compositions comprising combinations of components (b) and (c) which together effect polymerisation on irradiation by near ultraviolet and/or visible light are less harmed by the absorption of ultraviolet light by certain pigments, notably titanium dioxide, which may be contained in the composition.

The photopolymerisable material (a) capable of polymerisation by an acid-catalysed mechanism to a polymeric material of a higher molecular weight state is of very wide scope. Clearly the choice of such material will be limited to an extent which depends upon the nature of the aromatic halonium salt (b) and on the nature of the material (c) and also upon the nature of the ultraviolet and/or visible light with which the photopolymerisable material is irradiated. As already stated it is one advantage of the compositions of the present invention that they may be sensitive to, and hence can be polymerised on irradiation with, visible light.

The term "polymerisable material" also includes curable materials, for example materials which are already of high molecular weight and which are cross-linked by the process of the present invention. Mixtures of polymerisable or curable materials (a) may be employed, as also may mixtures of one or more polymerisable or curable materials (a) with resins which are not polymerisable by an acid-catalysed mechanism for example alkyd resins. Materials containing polymerisable cyclic groups may be employed, notably cyclic ethers for example lactones and acrolein tetramer and especially epoxides and episulphides, and polymers thereof containing polymerisable cyclic groups. Epoxides and episulphides containing from 2 to 20 carbon atoms are suitable, for example the cycloaliphatic epoxides, ethylene oxide, ethylene sulphide, propylene oxide and propylene sulphide, as also are compounds containing two or more epoxide or episulphide groups. Epoxy and episulphide resins may be used, for example the epoxy resins commonly known as Araldite epoxy resins. Other resins curable by an acid-catalysed mechanism which may be used include phenolic resins, for example phenol/formaldehyde resins, aminoplastics for example urea/formaldehyde and melamine/formaldehyde resins, methylol compounds, methylol ethers of polycarboxylic acid amides, for example derivatives of polyacrylic and polymethacrylic acid amides, alkyd resins containing urethane groups and resins containing carbonic acid esters of N-methylolamides. Acid-polymerisable or acid-curable ethylenically unsaturated materials may also be used, for example vinyl carbazole, vinyl ethers and diketene (which is both ethylenically unsaturated and a lactone). Resinous materials containing cross-linking agents which can be cured by acids are included.

Preferably the polymerisable compositions of this invention do not contain any significant proportion of material which is polymerisable by free radicals for example radical-polymerisable ethylenically unsaturated materials, since it is our intention that the significant proportion of free radicals which is generated by material (c) on radiation, although capable of polymerising such materials is utilised to the fullest extent in promoting the acid-catalysed polymerisation.

The compositions of the invention may be used in any of the applications for which materials polymerisable by an acid-catalysed mechanism are normally employed, provided that, if the composition is to be polymerised or cured *in situ,* irradiation of the composition is possible. Thus the compositions may be used, for example, for forming surface coatings on a variety of substrates, e.g. wood, paper, metals and textiles, and in printing inks. They may be used as adhesives in applications where they can be subjected *in situ* to radiation, for example in the formation of laminates wherein one or both of the lamina is permeable to radiation, e.g. glass lamina and some plastic lamina. The compositions have the property that only those regions contacted by radiation are polymerised or cured so that they may be used for example in the production of decorative articles having a contoured surface by exposing parts of the surface to radiation to cure those parts and subsequently removing uncured material from the surface. Thus they may be used, for example in the production of printing plates and printed circuits.

The invention is illustrated by the following Examples in which parts and percentages are by weight.

## Example 1

A series of compositions each containing 3 parts of 4,4' - dimethyl - diphenyliodonium hexafluorophosphate in 100 parts of 3,4, epoxy - cyclohexylmethyl 3,4 epoxy - cyclohexyl carboxylate (commercially obtainable as "ERL 4221" from Union Carbide) were each mixed with 1 part of one of the additives listed below and were coated onto glass plates as films 25$\mu$ in thickness. These films were irradiated using a Thorn Graph-X® 400w lamp emitting radiation in the wavelength range 330—500 nm but predominantly in the visible

region at a distance of 0.102 m from the lamp, and the time taken for curing of the film to form clear, hard, tack-free coatings was determined. The films could not be removed by rubbing with acetone after 100 double rubs.

| Additive | Cure Time (seconds) |
|---|---|
| None | greater than 1500 |
| 2-isopropylthioxanthone | 30 |
| thioxanthone | 30 |
| phenanthraquinone | 30 |
| piperonal | 60 |
| Anthrone | 200 |
| tetra-acetyl riboflavin | 300 |
| anthraquinone | 960 |
| 2-tert butyl anthraquinone | 630 |

2-isopropylthioxanthone has a solubility in acetone of 30% w/v whereas 2-chlorothioxanthone, anthraquinone and 2-tert-butyl anthraquinone have a solubility of less than 3% w/v.

Example 2

A mixture containing 3 parts of 3,3' - dinitro - diphenyliodonium hexafluorophosphate and 1 part of isopropylthioxanthone in 100 parts of the epoxy material used in Example 1 ("ERL 4221" Union Carbide) was coated onto a glass plate to form a film of 25$\mu$ thickness. When this film was irradiated, at a distance of 0.102 m using a Thorn Graph-X 400w lamp, a clear, hard, tack-free coating was produced after 20 seconds. A similar mixture which did not contain isopropylthioxanthone was still tacky after 700 seconds irradiation.

Example 3

A solution of 3 parts of 4,4'-dimethyldiphenyliodonium hexafluorophosphate in 100 parts of diglycidyl ether of bisphenol-A (available as "GY250" for Ciba-Geigy) was prepared. To this solution was then added 1 part of one of the compounds listed below and a control experiment was also carried out. 25 micron thick films were spread on glass and irradiated, at a distance of 0.102 m, using a Thorn Graph-X 400 w lamp. The time taken for the formation of clear, hard, tack-free films was determined.

| Additive | Cure Time (seconds) |
|---|---|
| None | 520 |
| isopropylthioxanthone | 40 |
| Benzil | 200 |
| 2,2-dimethoxy-2-phenyl-acetophenone | 180 |

Example 4

A solution was prepared containing 1 part of 4,4' - dimethyl - diphenyliodonium hexafluorophosphate in 100 parts of "GY250" (Ciba Geigy), as used in Example 3. To this solution was added 0.5 parts of one of the compounds listed below. The other compounds were examined and a control was carried out with three similar solutions. 25 $\mu$m thick films were spread on glass and exposed to predominantly ultraviolet radiation by passing below a 78.7 W/cm medium pressure mercury vapour lamp at a rate of 6.10 m per minute. The number of passes required to produce a hard, tack-free film is given below

| Additive | Number of passes |
|---|---|
| None | 5 |
| Benzophenone | 3 |
| 2,2 dimethoxy, 2, phenyl-acetophenone | 3 |
| Benzoin isopropyl ether | 4 |

Example 5

A coating formulation was prepared comprising 12% by volume rutile titanium dioxide dispersed in 100 parts of a diglycidyl ether of bisphenol A (commercially available as "DER 331" from Dow Chemicals). To this was added 3 parts of 4,4' - dimethyl - diphenyliodonium hexafluorophosphate and 1 part of isopropylthioxanthone.

A 12 $\mu$m thick film was converted to a hard, tack-free glossy white coating after 3 passes at 20 feet/minute beneath a 78.7 W/cm medium pressure mercury vapour lamp as in Example 4, providing predominantly ultraviolet radiation but also a proportion of radiation in the visible region of the wavelength spectrum.

Example 6

A solution of 1 part of 4,4' - dimethyl -

diphenyliodonium hexafluoroantimonate was prepared in 100 parts of the commercially available epoxide "ERL 4221". To this solution was added 3 parts of 2-isopropylthioxanthone and the mixture applied as a coating to glass and irradiated as in Example 3. A clear hard tack-free film was obtained after 15 seconds, whereas in the absence of the isopropylthioxanthone the coating remained tacky after several minutes.

When the 2-isopropylthioxanthone was replaced by 0.5 part of 2,2-dimethoxy-2-phenyl acetophenone and only 1 part of the same iodonium salt was used, a tack-free coating was obtained after 4 minutes 50 seconds. When no free radical source was present, the coating was still uncured after 6 minutes.

When the hexafluoroantimonate was replaced by the corresponding hexafluoroarsenate similar results were obtained over a little longer cure time.

## Claims

1. A photopolymerisable composition capable of polymerisation by an acid-catalysed mechanism under the influence of ultraviolet and/or visible light which comprises the components:

(a) At least one material capable of polymerisation by an acid-catalysed mechanism to a polymeric material of higher molecular weight state;

(b) a photosensitive aromatic halonium salt which is represented by the formula:

I) 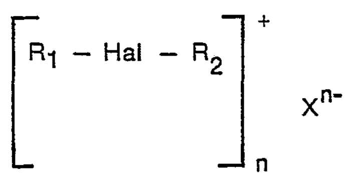

or

II) 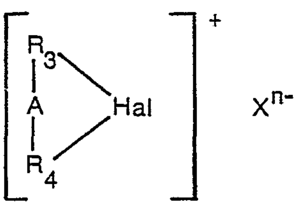

wherein n is 1 or 2; Hal is a halogen radical selected from Cl, Br and I; $R_1$ and $R_2$ are monovalent aromatic carbocyclic or aromatic heterocyclic organic radicals containing 4—20 carbon atoms, the same or different which may be substituted; $R_3$ and $R_4$ are divalent aromatic carbocyclic or aromatic heterocyclic radicals containing 4—20 carbon atoms, the same or different, which may be substituted and which may be directly linked through a carbon-carbon bond (when A = a direct bond) or indirectly linked when A is a hetero atom or a group containing a hetero atom or an alkyl or alkenyl radical containing 4—20 carbon atoms; and $X^{n-}$ is an anion derived from an acid which is capable of polymerising the material (a) of the composition by an acid-catalysed mechanism to a higher molecular weight state; and

(c) a conventional photosensitive free radical generator other than 2-chlorothioxanthone which under the influence of ultraviolet and/or visible light generates a significant proportion of free radicals which are readily converted to the corresponding carbocation by the halonium salt either (i) by intramolecular cleavage, or (ii) by intermolecular hydrogen abstraction in conjunction with a component of the composition other than the photosensitive aromatic halonium salt.

2. A photopolymerisable composition according to claim 1 wherein the photosensitive aromatic halonium salt is an iodonium salt.

3. A photopolymerisable composition according to claim 1 or claim 2 wherein a component (c)(i) is selected from benzoin and benzoin alkyl ethers; substituted acetophenones, for example dialkoxyacetophenones, alkoxy aryl acetophenones, 1-phenyl-1, 2-propanedione-2-O benzoyl oxime and halogenated acetophenones; or a component (c)(ii) is selected from aromatic diketones and substituted aromatic diketones; benzophenone and substituted benzophenones; materials of structure

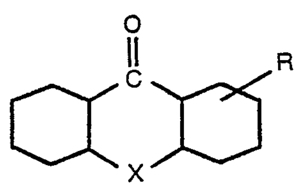

wherein X = O, S, $CH_2$ or a direct carbon-carbon bond and R = H, and substituted materials of the above structure where R = halogen (except 2-chloro-), alkyl or substituted alkyl; compounds capable of diradical formation; and piperonal.

4. A photopolymerisable composition according to any of claims 1 to 3 comprising a further component (d) which plays no part in the polymerisation process but which, when the composition is irradiated with ultraviolet and/or visible light, absorbs at least some of that radiation to which, in the absence of said component (d), the iodonium salt would be sensitive.

5. A photopolymerisable composition according to any of claims 1—4, wherein $X^{n-}$ is selected from $BF_4^-$, $SbCl_6^-$, $SbF_6^-$, $SnCl_6^{--}$, $PF_6^-$, $AsF_6^-$, $FeCl_4^-$, $BiCl_5^{--}$, or $R_5SO_3^-$ where $R_5$ is an aromatic hydrocarbon radical having 6—13 carbon atoms, an alkyl radical having 1—8 carbon atoms, and halogenated derivatives thereof, or $R_5$ is fluorine.

6. A photopolymerisable composition according to any one of claims 1 to 5, wherein there is present 0.01 to 10% by weight based on the composition of the component (c).

7. A photopolymerisable composition according to any one of claims 1 to 6, wherein the material capable of polymerisation to a higher molecular weight state is selected from epoxides, episulphides, and other cyclic ethers and thioethers; epoxy resins; episulphide resins; vinyl ethers; phenolic resins; and aminoplasts.

8. A coating composition which comprises a photopolymerisable composition according to claim 4 and in which the component (d) is a pigment.

9. A polymerised composition obtained by irradiating with ultraviolet and/or visible light a composition according to any of claims 1 to 8.

**Patentansprüche**

1. Photopolymerisierbare Zusammensetzung, die durch einen säurekatalysierten Mechanismus unter dem Einfluß von ultraviolettem und/oder sichtbarem Licht polymerisierbar ist und die die folgenden Komponenten enthält:

(a) mindestens ein Material, das durch einen säurekatalysierten Mechanismus in ein polymeres Material mit höherem Molekulargewicht polymerisierbar ist;

(b) ein photosensibles aromatisches Haloniumsalz der Formel:

I) 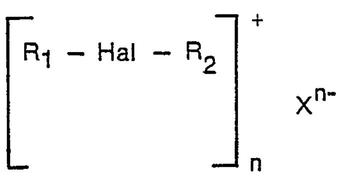

oder

II) 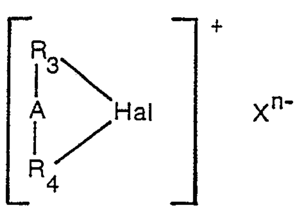

worin n für 1 oder 2 steht; Hal für ein aus Cl, Br und J ausgewähltes Halogenradikal steht; $R_1$ und $R_2$ für gleiche oder verschiedene einwertige aromatische carbocyclische oder aromatische heterocyclische organische Radikale mit 4 bis 20 Kohlenstoffatomen stehen, die substituiert sein können; $R_3$ und $R_4$ für gleiche oder verschiedene zweiwertige aromatische carbocyclische oder aromatische heterocyclische Radikale mit 4 bis 20 Kohlenstoffatomen stehen, die substituiert sein können und die direkt durch eine Kohlenstoff-Kohlenstoff-Bindung miteinander verbunden wein können, wobei A eine direkte Bindung darstellt, oder die indirekt miteinander verbunden sein können, wobei A ein Heteroatom oder eine ein Heteroatom enthaltende Gruppe oder ein Alkyl- oder Alkenylradikal mit 4 bis 20 Kohlenstoffatomen darstellt; und $X^{n-}$ für ein Anion steht, das sich von einer Säure ableitet, welche das Material (a) der Zusammensetzung durch einen säurekatalysierten Mechanismus auf ein höheres Molekulargewicht polymerisieren kann; und

(c) einen herkömmlichen photosensiblen Bildner von freien Radikalen mit Ausnahme von 2-Chlorothioxanthon, der unter dem Einfluß von ultraviolettem und/oder sichtbarem Licht eine beträchtliche Menge freier Radikale bildet, die leicht durch das Haloniumsalz in das entsprechende Carbokation umgewandelt werden können, und zwar entweder (i) durch intramolekulare Spaltung oder (ii) durch intermolekularen Wasserstoffabzug im Zusammenhang mit einer anderen in der Zusammensetzung vorhandenen Komponente als dem photosensiblen aromatischen Haloniumsalz.

2. Photopolymerisierbare Zusammensetzung nach Anspruch 1, bei welcher das photosensible aromatische Haloniumsalz ein Jodoniumsalz ist.

3. Photopolymerisierbare Zusammensetzung nach Anspruch 1 oder 2, bei welcher eine Komponente (c) (i) ausgewählt ist aus Benzoin und Benzoinalkyläthern; substituierten Acetophenonen, wie zum Beispiel Dialkoxyacetophenonen, Alkoxy - aryl - acetophenonen, 1 - Phenyl - 1,2 - propandion - 2 - O - benzoyl - oxim und halogenierten Acetophenonen; oder eine Komponente (c) (ii) ausgewählt ist aus aromatischen Diketonen und substituierten aromatischen Diketonen; Benzophenon und substituierten Benzophenonen; Materialien der Struktur

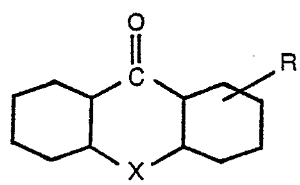

worin X = O, S, $CH_2$ oder eine direkte Kohlenstoff-Kohlenstoff-Bindung und R = H, und substituierten Materialien der obigen Struktur, worin R = Halogen (außer 2-Chloro-), Alkyl oder substituiertes Alkyl; Verbindungen, die ein Diradikal bilden können; und Piperonal.

4. Photopolymerisierbare Zusammensetzung nach einem der Ansprüche 1 bis 3, welche eine weitere Komponente (d) enthält, die bei dem Polymerisationsprozeß keine Rolle spielt, die aber, wenn die Zusammensetzung mit ultraviolettem und/oder sichtbarem Licht bestrahlt wird, mindestens einen Teil der Strahlung absorbiert, gegenüber welcher in Abwesenheit der Komponente (d) das Jodoniumsalz sensibel sein würde.

5. Photopolymerisierbare Zusammensetzung nach einem der Ansprüche 1 bis 4, bei welcher $X^{n-}$ ausgewählt ist aus $BF_4^-$, $SbCl_6^-$, $SbF_6^-$, $SnCl_6^{--}$, $PF_6^-$, $AsF_6^-$, $FeCl_4^-$, $BiCl_5^{--}$, oder $R_5SO_3^-$, worin $R_5$ für ein aromatisches Kohlenwasserstoffradikal mit 6 bis 13 Kohlenstoffatomen, ein Alkylradikal mit 1 bis 8 Kohlenstoffatomen, ein halogeniertes Derivat dan oder Fluor steht.

6. Photopolymerisierbare Zusammensetzung nach einem der Ansprüche 1 bis 5, bei welcher 0,01 bis 10 Gew.-% der Komponente (c), bezogen auf die Zusammensetzung, enthalten sind.

7. Photopolymerisierbare Zusammensetzung nach einem der Ansprüche 1 bis 6, bei welcher das Material, das auf ein höheres Molekulargewicht polymerisierbar ist, ausgewählt ist aus Epoxiden, Episulfiden und anderen cyclischen Äthern und Thioäthern; Epoxyharzen; Episulfidharzen; Vinyläthern; Phenolharzen; und Aminoplasten.

8. Beschichtungszusammensetzung, welche eine photopolymerisierbare Zusammensetzung nach Anspruch 4 enthält und bei welcher die Komponente (d) ein Pigment ist.

9. Polymerisierte Zusammensetzung, welche durch Bestrahlung einer Zusammensetzung nach einem der Ansprüche 1 bis 8 mit ultraviolettem und/oder sichtbarem Licht erhalten worden ist.

## Revendications

1. Composition photopolymérisable susceptible de polymérisation par un mécanisme catalysé par les acides sous l'influence de la lumière ultraviolette et/ou visible, qui comprend les constituants:

(a) au moins une matière susceptible de polymérisation par un mécanisme catalysé par les acides en une matière polymère d'un état de poids moléculaire supérieur,

(b) un sel d'halonium aromatique photosensible représenté par la formule:

I) $$\left[ R_1 - Hal - R_2 \right]^{+}_{n} \quad X^{n-}$$

ou

II) 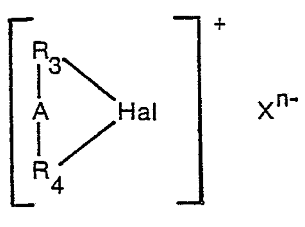

où n représente 1 ou 2, Hal représente un radical d'halogène choisi entre Cl, Br et I; $R_1$ et $R_2$ représentent des radicaux carbocycliques aromatiques ou hétérocycliques aromatiques monovalents comptant 4—20 atomes de carbone, qui sont identiques ou différents et qui peuvent être substitués; $R_3$ et $R_4$ représentent des radicaux carbocycliques aromatiques ou hétérocycliques aromatiques divalents comptant 4—20 atomes de carbone, qui peuvent être identiques ou différents, qui peuvent être substitués et qui peuvent être unis directement par une liaison carbone-carbone (lorsque A est une liaison directe) ou unis indirectement lorsque A est un hétéroatome ou un radical contenant un hétéroatome ou un radical alcoyle ou alcényle comptant 4—20 atomes de carbone, et $X^{n-}$ est un anion issu d'un acide qui est capable de polymériser la matière (a) de la composition par un mécanisme catalysé par les acides jusqu'à un état de poids moléculaire supérieur, et

(c) un générateur de radicaux libres photosensible classique autre que la 2-chlorothioxanthone qui, sous l'influence de la lumière ultraviolette et/ou visible, engendre une proportion sensible de radicaux libres qui sont aisément convertis en le carbocation correspondant par le sel d'halonium soit (i) par scission intramoléculaire, soit (ii) par élimination intermoléculaire d'hydrogène conjointement avec un constituant de la composition autre que le sel d'halonium aromatique photosensible.

2. Composition photopolymérisable suivant la revendication 1, dans laquelle le sel d'halonium aromatique photosensible est un sel d'iodonium.

3. Composition photopolymérisable suivant la revendication 1 ou 2, dans laquelle le constituant (c)(i) est choisi parmi la benzoïne et les éthers alcoyliques de benzoïne; les acétophénones substituées, par exemple les dialcoxyacétophénones, les alcoxyarylacétophénones; la 1 - phényl - 1,2 - propanedione - 2 - O-benzoyloxime et les acétophénones halogénées; ou un constituant (c)(ii) est choisi parmi les dicétones aromatiques et dicétones aromatiques substituées, la benzophénone et les benzophénones substituées, les composés de formule:

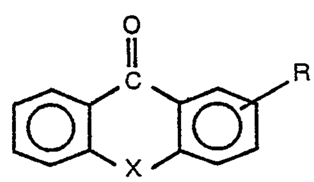

où X représente O, S, $CH_2$ ou une liaison directe carbone-carbone et R représente H, et les composés substitués de la formule ci-dessus où R représente un halogène (sauf 2-chloro) ou un radical alcoyle ou alcoyle substitué; les composés capables de former des diradicaux et le pipéronal.

4. Composition photopolymérisable suivant l'une quelconque des revendications 1 à 3, qui comprend un constituant (d) supplémentaire qui ne joue pas de rôle dans le processus de polymérisation, mais qui, lorsque la composition est irradiée en lumière ultraviolette et/ou visible, absorbe au moins une partie du rayonnement auquel, en l'absence du constituant (d), le sel d'iodonium serait sensible.

5. Composition photopolymérisable suivant l'une quelconque des revendications 1 à 4, dans laquelle $X^{n-}$ est choisi entre $BF_4^-$, $SbCl_6^-$, $SbF_6^-$, $SnCl_6^{--}$, $Pf_6^-$, $AsF_6^-$, $FeCl_4^-$, $BiCl_5^{--}$ et $R_5SO_3^-$, où $R_5$ représente un radical hydrocarboné aromatique comptant 6 à 13 atomes de carbone, un radical alcoyle comptant 1 à 8 atomes de carbone, et leurs dérivés halogénés ou bien $R_5$ représente le fluor.

6. Composition photopolymérisable suivant l'une quelconque des revendications 1 à 5, qui contient 0,01 à 10% en poids de constituant (c), sur base de la composition.

7. Composition photopolymérisable suivant l'une quelconque des revendications 1 à 6, dans laquelle le matière susceptible de polymérisation jusqu'à un état de poids moléculaire supérieur est choisie parmi les époxydes, les épisulfures et d'autres éthers et thioéthers cycliques, les résines époxydes, les résines épisulfures, les éthers vinyliques, les résines phénoliques et les résines aminoplastes.

8. Composition de revêtement qui comprend une composition photopolymérisable suivant la revendication 4, et dans laquelle le constituant (d) est un pigment.

9. Composition polymérisée obtenue par irradiation en lumière ultraviolette et/ou visible d'une composition suivant l'une quelconque des revendications 1 à 8.